# FASCICULE DE BREVET EUROPEEN

(11) **EP 0 913 836 B1**
(45) Date de publication et mention de la délivrance du brevet: **18.07.2001**
(21) Numéro de dépôt: 98470024.5
(22) Date de dépôt: 12.10.1998
(51) Int. Cl.: G11C 16/06, G11C 5/14

(54) **Circuit générateur de tension pour programmer ou effacer une mémoire qui utilise des transistors à grille flottante**
Schaltungsanordnung zur Erzeugung einer Spannung zum Programmieren oder Löschen von Halbleiter-Speicherzellen mit schwebendem Gate
Voltage generating circuit for programming or erasing a floating gate memory

(30) Priorité: 29.10.1997 FR 9713751
(43) Date de publication de la demande: 06.05.1999
(73) Titulaire: STMicroelectronics SA, 94250 Gentilly Cedex (FR)
(72) Inventeur: Naura, David, 57000 Metz (FR); Zink, Sébastien, 57000 Metz (FR)
(74) Mandataire: Ballot, Paul Denis Jacques

(56) Documents cités:
- EP-A- 0 811 987
- WO-A-97/48100
- GB-A- 2 288 678
- US-A- 5 101 381
- US-A- 5 408 133

## Description

L'invention concerne un circuit générateur de tension pour programmer ou effacer une mémoire qui utilise des transistors à grille flottante. L'invention se rapporte plus particulièrement au générateur qui fournit aux cellules de mémorisation des créneaux de tension afin de les effacer ou de les programmer.

La programmation et l'effacement des informations contenues dans des transistors à grille flottante se fait par l'application de tensions élevées entre grille et drain afin de charger ou décharger la grille flottante par effet tunnel. La tension à appliquer au transistor doit être progressive afin d'éviter un claquage de l'isolant. De nombreux générateurs de rampe de tension sont connus. Un système générateur de rampe est décrit par exemple dans les demandes EP-A-0 762 428 et EP-A-O 811 987.

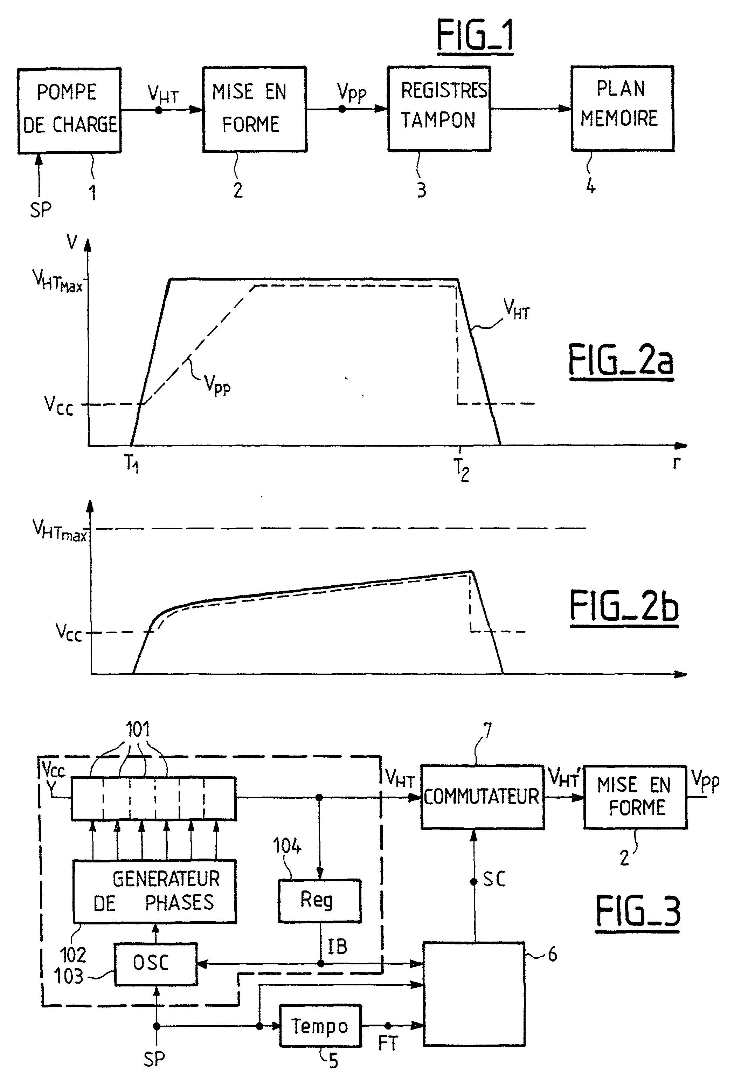

Sur la figure 1, il a été représenté les circuits mis en oeuvre lors de la programmation d'une mémoire à grille flottante. Une pompe de charge 1 fournit une tension dite pompée V_{HT}. Cette pompe de charge 1 est commandée par un signal de programmation SP de type binaire. Le signal de programmation SP autorise le fonctionnement de la pompe de charge pendant la programmation. Un circuit de mise en forme 2 reçoit la tension pompée V_{HT} et produit une tension de programmation Vpp dont la croissance est régulée progressivement afin de ne pas endommager les transistors de mémorisation. La tension de programmation Vpp sert à alimenter des registres tampon 3 dans lesquels les données à programmer ont été préalablement chargées. Un ou plusieurs des registres tampon 3 est relié à un plan mémoire 4. L'augmentation de la tension de programmation V_{PP} provoque l'augmentation progressive la tension en sortie des registres tampon 3 ce qui a pour effet d'écrire le contenu d'au moins un des registres tampon 3 dans le plan mémoire.

L'effacement s'effectue selon un principe similaire comportant cependant quelques différences. On peut par exemple remplacer les registres tampons par des circuits décodeurs de lignes pour inverser la polarisation des cellules ou par exemple utiliser les mêmes circuits avec une tension de programmation négative.

Dans le cas d'une programmation, le fonctionnement idéal, pour un créneau de tension, de la pompe de charge 1 et du circuit de mise en forme 2 est représenté sur la figure 2a. A l'instant T₁, le signal de programmation est activé ce qui provoque la croissance rapide de la tension pompée V_{HT} qui va croître jusqu'à une tension pompée maximale V_{HTMAX}, la tension pompée V_{HT} étant régulée pour être maintenue à V_{HTMAX}. A l'instant T₂, le signal de programmation est désactivé ce qui met fin à la programmation, la pompe de charge 1 s'arrête et la tension pompée V_{HT} diminue jusqu'à 0 V. La tension V_{PP} est une tension constante égale à la tension d'alimentation V_{CC} du circuit intégré lorsque le signal de programmation SP est désactivé. Lorsque le signal de programmation SP est actif, la tension de programmation Vpp devient égale à la tension pompée V_{HT}. Cependant, le circuit de mise en forme limite la croissance de la tension de programmation Vpp pour ne pas endommager les transistors de mémorisation.

La figure 2a correspond à un fonctionnement normal avec une pompe de charge qui peut fournir un courant suffisant. Dès que la tension de programmation Vpp croit, la pompe de charge doit fournir un courant aux circuits alimentés par la tension de programmation V_{PP}, c'est à dire les registres tampon 3 chargés par les transistors de mémorisation du plan mémoire auxquels ils sont reliés. Le courant fourni par la pompe de charge est d'autant plus important que la croissance de la tension de programmation Vpp est importante.

Si la pompe de charge est sous dimensionnée, le fonctionnement devient celui représenté sur la figure 2b. Sur cette figure 2b, on peut voir que la tension pompée V_{HT} croit rapidement jusqu'à ce que la tension de programmation Vpp commence à croître. La pompe de charge doit fournir un courant important aux registres tampon qui limite fortement la croissance de la tension pompée VHT. La figure 2b représente un cas extrême où la pompe de charge 1 ne permet pas d'atteindre la tension V_{HTMAX} nécessaire pour assurer la programmation.

Pour éviter de tel problème, l'homme du métier doit dimensionner la pompe de charge 1 en fonction du courant maximal qu'elle devra fournir tout en pouvant augmenter rapidement la tension pompée V_{HT}. L'homme du métier sait que le courant maximal de sortie de la pompe de charge est proportionnel à C * F / n, C étant la capacité des condensateurs utilisés dans les étages de sortie de la pompe, F étant la fréquence de pompage, et n le nombre d'étages de sortie de la pompe. Le nombre d'étages de sortie est fixé en fonction de la tension désirée et de la tension d'alimentation du circuit intégré. L'augmentation de la fréquence de pompage entraîne l'augmentation de la consommation, des problèmes d'émission de parasites (rayonnement), et des risques de décrochage (commutation trop rapide des étages de sortie). L'augmentation des capacités entraîne une augmentation de la taille de la pompe.

A l'heure actuelle la programmation (ou l'effacement) peut se faire par mot, par page de mots ou de manière globale (toute la mémoire). La programmation globale étant essentiellement utilisée pour diminuer la durée des tests constructeur de la mémoire. Un système dimensionné pour effectuer dans de bonnes conditions une programmation globale est surdimensionné pour la programmation d'un mot. Le surdimensionnement est d'autant plus important que la capacité de la mémoire (en taille) est importante.

L'invention propose de résoudre les problèmes de surdimensionnement de la pompe en charge. Dans l'invention, un circuit de commutation est ajouté pour commuter la tension pompée après un certain temps pour que la tension pompée atteigne un niveau suffisant avant d'avoir à débiter un fort courant. La pompe de charge selon l'invention doit être calculée uniquement pour maintenir la tension pompée à sa valeur maximale en charge ce qui permet d'avoir une pompe de charge de taille plus réduite.

L'invention a pour objet une mémoire à grille flottante selon la revendication 1 et un procédé selon la revendication 5.

Selon différents modes de réalisation, les moyens de commande comportent soit un circuit de détection de tension pour détecter que la tension pompée a atteint une tension de référence et rendre actif le signal de commande dès que la tension pompée a atteint la tension de référence, soit un circuit de temporisation pour rendre actif le signal de commande après qu'une durée prédéterminée se soit écoulée à partir de la mise en route de la pompe de charge, ou soit un circuit de détection de tension et un circuit de temporisation pour rendre actif le signal de commande dès que la tension pompée a atteint une tension de référence ou dès que la pompe de charge est activée depuis une durée prédéterminée. Pour chaque mode de réalisation, le circuit de commutation fournit la tension commutée égale à la tension pompée au circuit de mise en forme lorsque le signal de commande est actif.

Selon différentes variantes, le signal de commande devient actif soit dès que la tension pompée a atteint une tension de référence, soit dès qu'une durée prédéterminée s'est écoulée après le début du pompage de la tension pompée, ou soit dès que la tension pompée a atteint une tension de référence ou dès qu'une durée prédéterminée s'est écoulée après le début du pompage de la tension pompée.

L'invention sera mieux comprise et d'autres particularités et avantages apparaîtront à la lecture de la description qui va suivre, la description faisant référence aux dessins annexés parmi lesquels:
la figure 1 représente un dispositif générateur de tension de programmation selon l'état de la technique,
les figures 2a et 2b représentent des courbes de fonctionnement du circuit de la figure 1
la figure 3 représente un circuit générateur de tension de programmation ou d'effacement selon l'invention,
la figure 4 représente le circuit de commutation utilisé dans l'invention,
les figures 5A à 5F et 6A à 6F représentent des courbes de fonctionnement de l'invention.

Sur la figure 3, le circuit représenté comporte la pompe de charge 1, le circuit de mise en forme 2, un circuit de temporisation 5, un circuit logique 6 et un circuit de commutation 7.

La pompe de charge 1 a été détaillée et comporte des étages de sorties montés en série, un circuit générateur de phases 102, un oscillateur 103, et un circuit de régulation 104.

Les étages de sortie 101 reçoivent chacun au moins un ou deux signaux de phase (suivant le type d'étages de sortie), une tension d'entrée et fournissent chacun une tension de sortie égale à la tension d'entrée augmentée de l'amplitude du signal de phase en régime établi. Le premier des étages de sortie 101 reçoit la tension d'alimentation du circuit V_{CC} et le dernier étage de sortie 101 fournit la tension pompée VHT.

Le générateur de phases 102 reçoit un signal d'horloge et produit deux ou quatre signaux de phase aux étages de sortie de manière alternée.

L'oscillateur 103 est de type commandé et possède des première et deuxième entrées de commande et fournit sur une sortie le signal d'horloge. Classiquement, l'oscillateur fonctionne lorsque les première et deuxième entrées sont toutes les deux dans un premier état et s'arrête dès que l'une des entrées est dans le deuxième état. La première entrée de l'oscillateur 103 reçoit le signal de programmation SP qui indique que la programmation est en cours lorsqu'il est dans le premier état.

Le circuit de régulation 104, reçoit la tension pompée V_{HT} et produit un indicateur binaire IB sur une sortie. La sortie du circuit de régulation 104 est connectée à la deuxième entrée de l'oscillateur 103. Lorsque la tension pompée V_{HT} est inférieure à une tension de référence qui est au moins égale à la tension nécessaire pour la programmation d'un transistor de mémorisation, l'indicateur binaire IB est dans le premier état. Lorsque la tension pompée V_{HT} est supérieure à la tension de référence, l'indicateur binaire IB est dans le deuxième état.

Pour plus de détails sur la réalisation et le fonctionnement de la pompe de charge 1, l'homme du métier peut se reporter par exemple aux demandes EP-A-0 382 929, EP-A-0 678 802, ou EP-A-0 757 427. qui concernent différents éléments de pompe de charge.

Le circuit de temporisation 5, possédant une entrée et une sortie, reçoit sur son entrée le signal de programmation et produit un indicateur de fin de temporisation FT sur sa sortie. L'indicateur de fin de temporisation FT est un signal de type binaire qui se positionne dans le premier état après une qu'une durée prédéterminée se soit écoulée à partir d'un front montant du signal de programmation SP. Lorsque le signal de programmation SP est dans le second état, le signal de fin de temporisation est positionné dans le deuxième état. Le circuit de temporisation 5 peut par exemple être réalisé à l'aide d'un circuit monostable ou à l'aide d'un compteur.

Le circuit logique 6 possède des première à troisième entrées binaires et une sortie logique. La première entrée binaire est connectée à la sortie du circuit régulateur 104 pour recevoir l'indicateur binaire IB. La deuxième entrée binaire reçoit le signal de programmation SP. La troisième entrée binaire reçoit l'indicateur de fin de temporisation FT. La sortie logique fournit un signal de commande SC qui est inactif lorsque le signal de programmation est dans le deuxième état et qui devient actif dès que le signal de programmation SP est dans le premier état et que l'indicateur binaire IB présente un front montant ou dès que le signal de programmation SP est dans le premier état et que le signal de fin de temporisation FT présente un front montant.

Le circuit de commutation 7 possède une entrée de commande, une entrée de tension et une sortie de tension. L'entrée de tension reçoit la tension pompée V_{HT}. l'entrée de commande reçoit le signal de commande SC. La sortie de tension fournit une tension commutée V_{HT}' qui est nulle lorsque le signal de commande est inactif et qui est égale à la tension pompée V_{HT} lorsque le signal de commande est actif.

Le circuit de mise en forme 2 reçoit la tension commutée V_{HT}' et fournit la tension de programmation Vpp. La tension de programmation Vpp est égale à la tension d'alimentation V_{CC} lorsque la tension commutée V_{HT}' est nulle. Dès que la tension commutée V_{HT}' est supérieure à la tension d'alimentation V_{CC}, la tension de programmation Vpp va croître de manière progressive jusqu'à atteindre une valeur maximale de tension de programmation. Le circuit de mise en forme peut par exemple être celui décrit dans la demande EP-A-0 762 428.

Dans une variante, il n'est pas nécessaire que le circuit de commutation fournisse une tension nulle. L'important est que le circuit de commutation 7 fournisse une tension neutre au circuit de mise en forme 2. Par tension neutre, on doit comprendre une tension qui rende le circuit de mise en forme inactif, à titre d'exemple, la tension neutre peut être comprise entre 0 V et la tension d'alimentation V_{CC}, ou encore correspondre à une sortie de type haute impédance dont la tension est fixée par le circuit de mise en forme 2.

Dans l'exemple décrit précédemment, il est question de programmation des transistors de mémorisation. Il est évident qu'un tel circuit est également utilisable pour l'effacement de ces mêmes transistors de mémorisation. Pour un effacement, les tensions appliquées aux transistors de mémorisation sont inversées par rapport à une programmation. Dans certaines mémoires seules des tensions positives sont utilisées, dans ce cas, il convient d'utiliser un aiguillage pour diriger la tension de programmation par exemple sur les circuits de décodage de lignes du plan mémoire lors de l'effacement. Si on utilise une tension d'effacement négative, il faut alors adapter la présente invention pour fonctionner avec des tensions négatives.

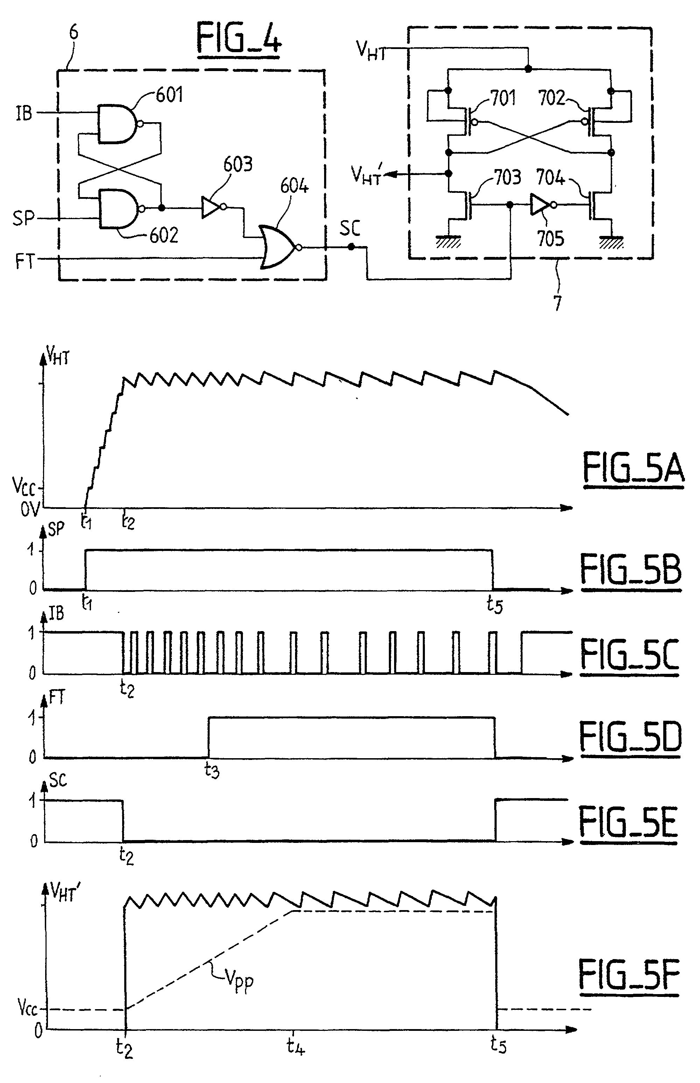

La figure 4 représente un mode de réalisation préféré du circuit logique 6 et du circuit de commutation 7.

Le circuit logique 6 comporte des première et deuxième portes ET-NON 601 et 602 à deux entrées, une porte inverseuse 603, et une porte OU-NON 604 à deux entrées. Les première et deuxième portes ET-NON 601 et 602 sont connectées pour former une bascule de type /R/S, une entrée de la première porte ET-NON 601 recevant l'indicateur binaire IB, et une entrée de la deuxième porte ET-NON 602 recevant la signal de programmation SP. L'entrée de la porte inverseuse 603 est connectée à la sortie de la deuxième porte ET-NON 602. La première entrée de la porte OU-NON 604 est connectée à la sortie de la porte inverseuse 603. La deuxième entrée de la porte OU-NON 604 reçoit le signal de fin de temporisation FT. La sortie de la porte OU-NON 604 fournit le signal de commande SC.

Le circuit de commutation 7 comporte des premier et deuxième transistors 701 et 702 de type P, des troisième et quatrième transistors 703 et 704 de type N, et un inverseur 705. Les sources des premier et deuxième transistors 701 et 702 sont connectées ensemble et reçoivent la tension pompée V_{HT}. Le drain du premier transistor 701 est connecté à la grille du deuxième transistor 702 et au drain du troisième transistor 703. Le drain du deuxième transistor 702 est connecté à la grille du premier transistor 701 et au drain du quatrième transistor 704. Les sources des troisième et quatrième transistors 703 et 704 sont connectées à la masse. La grille du troisième transistor 703 et l'entrée de l'inverseur 705 sont connectées ensemble à la sortie du circuit logique 6 et reçoivent le signal de commande SC. La grille du quatrième transistor 704 est connectée à la sortie de l'inverseur 705. La tension commutée V_{HT}' est fournit par le noeud constitué par les drains des premier et troisième transistors 701 et 703.

L'invention peut être résumée à un retard dans la fourniture de la tension pompée V_{HT} au circuit de mise en forme 2. Le retard est induit dans l'exemple préféré par un circuit de commande qui comporte un circuit de détection de tension qui est le circuit de régulation 104 de la pompe de charge 1, le circuit de temporisation 5 et le circuit logique 6.

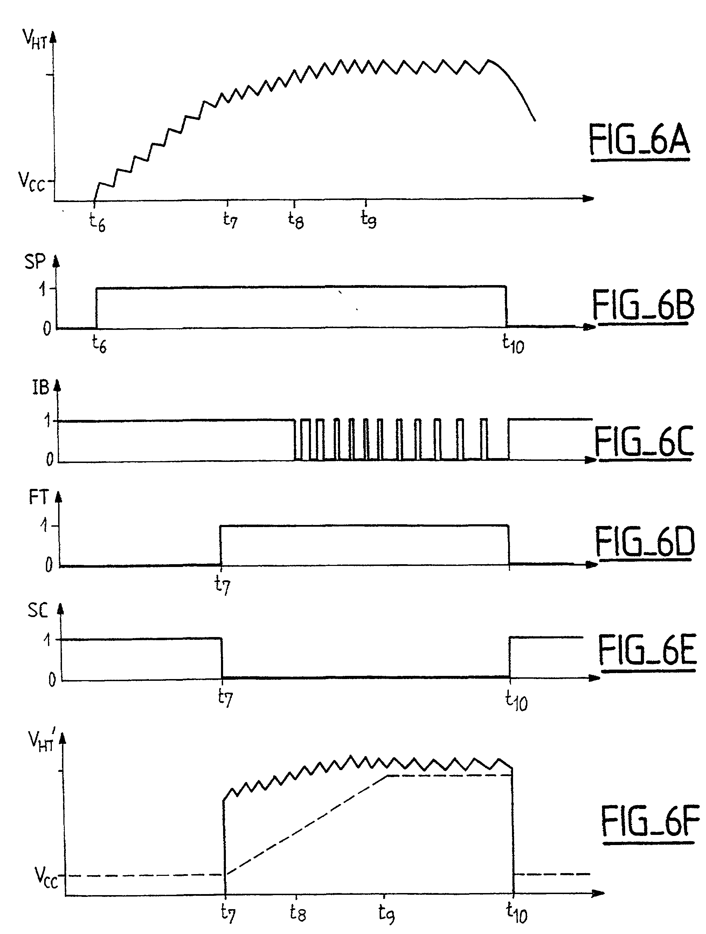

Les figures 5A à 5F représentent les chronogrammes de fonctionnement de l'invention dans le cas où la pompe de charge est "rapide". Dans l'exemple représenté, on a une tension d'alimentation V_{CC} égale à 3 V, une tension de référence de 18 V pour le circuit de régulation 104, et une tension maximale de programmation de 16,5 V régulée par le circuit de mise en forme 2.

La figure 5A représente la tension pompée V_{HT} de sortie de pompe de charge. Les dents de scie correspondent au pompage de la pompe de charge et sont relativement accentuées par rapport à la réalité.

Les figures 5B à 5D représentent respectivement le signal de programmation SP, l'indicateur binaire IB et le signal de fin de temporisation FT. Pour les figures 5B à 5D, le premier état correspond à un état logique "1" et le deuxième état correspond à un état logique "0".

La figure 5E représente le signal de commande SC, ici actif au niveau logique "0".

La figure 5F représente la tension commutée V_{HT}' en trait plein et la tension de programmation Vpp en trait pointillé. La tension de programmation V_{PP} présente une croissance simple dans le but de simplifier le dessin.

A l'instant t₁, le signal de programmation devient actif, ce qui déclenche le pompage de la pompe de charge 1. A l'instant t₂, la tension pompée atteint la valeur maximale ce qui positionne l'indicateur binaire IB dans le deuxième état, le signal de commande devient actif, rendant la tension commutée V_{HT}' égale à la tension pompée V_{HT} et de ce fait la tension de programmation Vpp va croître. A l'instant t₃, la temporisation se termine, le signal de fin de temporisation passe dans le premier état sans incidence sur le reste du circuit. A l'instant t₄, la tension de programmation V_{PP} atteint sa valeur maximale. A l'instant t₅, le signal de programmation SP passe dans le deuxième état, indiquant la fin de la programmation, ce qui a pour effet de rendre inactif le signal de commande SC et de rendre nulle la tension commutée V_{HT}', la tension de programmation V_{PP} devient alors égale à la tension d'alimentation V_{CC}.

Entre les instants t₂ et t₄, la croissance de la tension de programmation appelle un courant plus important qu'entre les instants t₄ et t₅ ce qui se traduit par une sollicitation plus importante de la pompe de charge mais qui influence peu la tension pompée V_{HT}.

Les figures 6A à 6F représentent les chronogrammes de fonctionnement de l'invention dans le cas où la pompe de charge est "lente". Dans l'exemple représenté, on a une tension d'alimentation V_{CC} égale à 3 V, une tension de référence de 18 V pour le circuit de régulation 104, et une tension maximale de programmation de 16,5 V.

La figure 6A représente la tension pompée V_{HT} de sortie de pompe de charge. Les dents de scies correspondent au pompage de la pompe de charge et sont relativement accentuées par rapport à la réalité.

Les figures 6B à 6D représentent respectivement le signal de programmation SP, l'indicateur binaire IB et le signal de fin de temporisation FT. Pour les figures 6B à 6D, le premier état correspond à un état logique "1" et le deuxième état correspond à un état logique "0".

La figure 6E représente le signal de commande SC, ici actif au niveau logique "0".

La figure 6F représente la tension commutée V_{HT}' en trait plein et la tension de programmation Vpp en trait pointillé. La tension de programmation Vpp présente une croissance simple dans le but de simplifier le dessin.

A l'instant t₆, le signal de programmation devient actif, ce qui déclenche le pompage de la pompe de charge 1. A l'instant t₇, la temporisation se termine, le signal de fin de temporisation passe dans le premier état, le signal de commande devient actif, rendant la tension commutée V_{HT}' égale à la tension pompée V_{HT} et de ce fait la tension de programmation Vpp va croître. A l'instant t₈, la tension pompée atteint la valeur maximale ce qui positionne l'indicateur binaire IB dans le deuxième état, sans incidence sur le reste du circuit. A l'instant t₉, la tension de programmation Vpp atteint sa valeur maximale. A l'instant t₁₀, le signal de programmation SP passe dans le deuxième état, indiquant la fin de la programmation, ce qui a pour effet de rendre inactif le signal de commande SC et de rendre nulle la tension commutée V_{HT}', la tension de programmation V_{PP} devient alors égale à la tension d'alimentation V_{CC}.

Entre les instants t₇ et t₉, la croissance de la tension de programmation appelle un courant plus important qu'entre les instants t₉ et t₁₀ ce qui se traduit par une sollicitation plus importante de la pompe de charge qui influence la valeur de la tension pompée VHT. En effet, à l'instant t₇, la tension pompée V_{HT} n'a pas encore atteint la tension de référence, la croissance de la tension pompée est ralentie. Cependant la temporisation a permis à la tension pompée V_{HT} d'atteindre un niveau suffisant pendant une durée suffisante, ce qui permet d'avoir un fonctionnement correcte du circuit de mise en forme 2.

Dans l'exemple décrit, le circuit de commande utilise la réunion de deux conditions, l'une sur la tension pompée et l'autre temporelle, par l'intermédiaire d'une fonction OU. Il est possible de se contenter d'un circuit de commande utilisant une seule condition et utilisant soit un circuit de détection de tension soit un circuit de temporisation.

Si on utilise un circuit de commande qui comporte uniquement le circuit de temporisation, il convient de remplacer le circuit logique par une porte inverseuse sur le schéma de la figure 4. La durée prédéterminée doit être calculée afin qu'à l'issue de cette durée, on soit sûr que la tension pompée V_{HT} ait atteint un niveau suffisant. Les tolérances sur les valeurs réelles des capacités et résistances d'un circuit intégré tendent à calculer la durée prédéterminée en fonction du pire cas qui puisse se présenter lors de la montée de la tension pompée V_{HT}. La durée ainsi calculée est relativement élevée pour tous les circuits qui fonctionnent mieux que le pire cas (c'est à dire 99 % des circuits produits). L'utilisation de la durée prédéterminée seule a pour effet de rendre fixe la durée d'application de la tension maximale de programmation en reproduisant le pire cas ce qui a pour effet d'augmenter le temps de programmation.

Si on utilise un circuit de commande qui comporte uniquement le circuit de détection de tension, on sera sûr d'avoir la valeur maximale de la tension pompée mais par contre on ne dispose d'aucun contrôle sur le retard engendré par l'obtention de la valeur. Il existe alors une possibilité très faible que le retard occasionné ne permette pas d'avoir une tension de programmation Vpp maximale pendant un temps suffisamment long pour assurer la programmation des cellules de mémorisation, ce qui aurait pour effet de baisser le rendement de production des mémoires par l'ajout d'une contrainte trop stricte.

L'homme du métier peut réaliser de nombreuses variantes de l'invention sans toutefois s'éloigner de l'objet de l'invention. Ainsi les différentes valeurs de tension et les niveaux logiques utilisés dans l'exemple peuvent être remplacés par d'autres en adaptant le circuit. Il est également possible d'utiliser un circuit de détection de tension différent du circuit régulateur de la pompe de charge afin d'utiliser une tension de référence différente de la valeur maximale de la tension pompée V_{HT} mais cela fait ajouter un circuit supplémentaire qui permet seulement un résultat équivalent.

## Revendications

1. Mémoire à grille flottante comportant un circuit générateur de tension pour la programmation ou l'effacement, le circuit générateur de haute tension comportant une pompe de charge (1) pour fournir une tension dite pompée (V_{HT}) et un circuit de mise en forme (2) pour fournir une tension dite de programmation ou d'effacement (V_{PP}) à partir de la tension pompée (V_{HT}), la croissance de la tension de programmation ou d'effacement (V_{PP}) étant progressive,
la mémoire étant caractérisée en ce que le circuit générateur comporte des moyens de commande (5, 6, 104) pour fournir un signal de commande (SC) et un circuit de commutation (7) connecté entre la pompe de charge et le circuit de mise en forme, le circuit de commutation fournissant une tension commutée (V_{HT}') égale soit à la tension pompée (V_{HT}) soit à une tension neutre (0V) en fonction du signal de commande (SC) au circuit de mise en forme (2), le signal de commande (SC) étant actif lorsque la tension pompée a atteint un niveau de tension suffisant.

2. Mémoire selon la revendication 1, caractérisée en ce que les moyens de commande comportent un circuit de détection de tension (104) pour détecter que la tension pompée (V_{HT}) a atteint une tension de référence et rendre actif le signal de commande (SC) dès que la tension pompée (V_{HT}) a atteint la tension de référence, et en ce que le circuit de commutation (7) fournit la tension commutée (V_{HT}') égale à la tension pompée (V_{HT}) au circuit de mise en forme (2) lorsque le signal de commande (SC) est actif.

3. Mémoire selon la revendication 1, caractérisée en ce que les moyens de commande comportent un circuit de temporisation (5) pour rendre actif le signal de commande (SC) après qu'une durée prédéterminée se soit écoulée à partir de la mise en route de la pompe de charge (1) et en ce que le circuit de commutation (7) fournit la tension commutée (V_{HT}') égale à la tension pompée (V_{HT}) au circuit de mise en forme (2) lorsque le signal de commande (SC) est actif.

4. Mémoire selon la revendication 1, caractérisée en ce que les moyens de commande comportent un circuit de détection de tension (104) et un circuit de temporisation (5) pour rendre actif le signal de commande (SC) dès que la tension pompée (V_{HT}) a atteint une tension de référence ou dès que la pompe de charge (1) est activée depuis une durée prédéterminée et en ce que le circuit de commutation (7) fournit la tension commutée (V_{HT}') égale à la tension pompée (V_{HT}) au circuit de mise en forme (2) lorsque le signal de commande (SC) est actif.

5. Procédé de production d'une tension de programmation ou d'effacement pour une mémoire à grille flottante au cours duquel une tension pompée (V_{HT}) est produite par une pompe de charge (1) et une tension de programmation ou d'effacement (Vₚₚ) est produite à partir de la tension pompée (V_{HT}) dans un circuit de mise en forme (2), la tension de programmation ou d'effacement (V_{PP}) ayant une croissance progressive,
le procédé étant caractérisé en ce que la tension pompée (V_{HT}) est fournie au circuit de mise en forme (2) lorsqu'un signal de commande (SC) actif est reçu, le signal de commande (SC) étant actif lorsque la tension pompée (V_{HT}) a atteint un niveau de tension suffisant.

6. Procédé selon la revendication 5, caractérisé en ce que le signal de commande (SC) devient actif dès que la tension pompée (V_{HT}) a atteint la tension de référence.

7. Procédé selon la revendication 5, caractérisé en ce que le signal de commande (SC) devient actif dès qu'une durée prédéterminée s'est écoulée après le début du pompage de la tension pompée (V_{HT}).

8. Procédé selon la revendication 5, caractérisé en ce que le signal de commande (SC) devient actif dès que la tension pompée (V_{HT}) a atteint une tension de référence ou dès qu'une durée prédéterminée s'est écoulée après le début du pompage de la tension pompée (V_{HT}).

## Patentansprüche

1. Speicher mit schwimmendem Gate, mit einer Schaltung zum Erzeugen einer Spannung zum Programmieren oder Löschen, wobei die Schaltung zum Erzeugen einer hohen Spannung eine Ladungspumpe (1) zum Liefern einer so genannten Pumpspannung (V_{HT}) und einen Pulsformer (2) zum Liefern einer so genannten Programmier- oder Löschspannung (V_{PP}) ausgehend von der Pumpspannung (V_{HT}) aufweist, wobei der Anstieg der Programmier-oder Löschspannung (V_{PP}) progressiv ist,
dadurch gekennzeichnet, dass die Schaltung Steuerungsmittel (5, 6, 104) zum Liefern eines Steuersignals (SC) und einen zwischen der Ladungspumpe und dem Pulsformer angeschlossenen Umschalter (7) aufweist, wobei der Umschalter eine Schaltspannung (V_{HT}') an den Pulsformer (2) liefert, die abhängig vom Steuersignal (SC) entweder gleich der Pumpspannung (V_{HT}) oder gleich einer neutralen Spannung (0V) ist, wobei das Steuersignal (SC) aktiv ist, wenn die Pumpspannung ein ausreichendes Spannungsniveau erreicht hat.

2. Speicher nach Anspruch 1, dadurch gekennzeichnet, dass die Steuermittel eine Spannungsdetektorschaltung (104) aufweisen, um zu ermitteln, ob die Pumpspannung (V_{HT}) eine Referenzspannung erreicht hat, und das Steuersignal (SC) aktiv zu setzen, sobald die Pumpspannung (V_{HT}) die Referenzspannung erreicht hat, und dadurch, dass der Umschalter (7) die der Pumpspannung (V_{HT}) gleiche Schaltspannung (V_{HT}') an den Pulsformer (2) liefert, wenn das Steuersignal (SC) aktiv ist.

3. Speicher nach Anspruch 1, dadurch gekennzeichnet, dass die Steuermittel einen Verzögerungskreis (5) aufweisen, um das Steuersignal (SC) aktiv zu setzen, nachdem eine vorher festgelegte Zeitspanne ab Ingangsetzen der Ladungspumpe (1) verstrichen ist, und dadurch, dass der Umschalter (7) die der Pumpspannung (V_{HT}') gleiche Schaltspannung (V_{HT'}) an den Pulsformer (2) liefert, wenn das Steuersignal (SC) aktiv ist.

4. Speicher nach Anspruch 1, dadurch gekennzeichnet, dass die Steuermittel eine Spannungsdetektorschaltung (104) und einen Verzögerungskreis (5) aufweisen, um das Steuersignal (SC) aktiv zu setzen, sobald die Pumpspannung (V_{HT}) eine Referenzspannung erreicht hat oder sobald die Ladungspumpe (1) eine vorher festgelegte Zeitspanne lang aktiviert ist, und dadurch dass der Umschalter (7) die der Pumpspannung (V_{HT}) gleiche Schaltspannung (V_{HT'}) an den Pulsformer (2) liefert, wenn das Steuersignal (SC) aktiv ist.

5. Verfahren zum Erzeugen einer Programmier- oder Löschspannung für einen Speicher mit schwimmendem Gate, bei dem eine Pumpspannung (V_{HT}) von einer Ladungspumpe (1) erzeugt wird und eine Programmier- oder Löschspannung (VPP) ausgehend von der Pumpspannung (V_{HT}) in einem Pulsformer (2) erzeugt wird, wobei die Programmier- oder Löschspannung (V_{PP}) progressiv ansteigt,
dadurch gekennzeichnet, dass die Pumpspannung (V_{HT}) an den Pulsformer (2) geliefert wird, wenn ein aktives Steuersignal (SC) erhalten wird, wobei das Steuersignal (SC) aktiv ist, wenn die Pumpspannung (V_{HT}) ein ausreichendes Spannungsniveau erreicht hat.

6. Verfahren nach Anspruch 5, dadurch gekennzeichnet, dass das Steuersignal (SC) aktiv wird, sobald die Pumpspannung (V_{HT}) die Referenzspannung erreicht hat.

7. Verfahren nach Anspruch 5, dadurch gekennzeichnet, dass das Steuersignal (SC) aktiv wird, nachdem eine vorher festgelegte Zeitspanne nach Beginn des Pumpens der Pumpspannung (V_{HT}) verstrichen ist.

8. Verfahren nach Anspruch 5, dadurch gekennzeichnet, dass das Steuersignal (SC) aktiv wird, sobald die Pumpspannung (V_{HT}) eine Referenzspannung erreicht hat oder sobald eine vorher festgelegte Zeitspanne nach Beginn des Pumpens der Pumpspannung (V_{HT}) verstrichen ist.

## Claims

1. Floating-gate memory having a voltage generating circuit for programming or erasure, the high-voltage generating circuit including a charge pump (1) for supplying a so-called pumped voltage (V_{HT}) and a shaping circuit (2) for supplying a so-called programming or erasure voltage (V_{PP}) from the pumped voltage (V_{HT}), the increase in the programming or erasure voltage (V_{PP}) being progressive,
the memory being characterised in that the generating circuit has control means (5, 6, 104) for supplying a control signal (SC) and a switching circuit (7) connected between the charge pump and the shaping circuit, the switching circuit supplying a switched voltage (V_{HT'}) equal either to the pumped voltage (V_{HT}) or to a neutral voltage (0V) according to the control signal (SC) to the shaping circuit (2), the control signal (SC) being active when the pumped voltage has reached a sufficient voltage level.

2. Memory according to Claim 1, characterised in that the control means include a voltage detection circuit (104) for detecting the fact that the pumped voltage (V_{HT}) has reached a reference voltage and making the control signal (SC) active as soon as the pumped voltage (V_{HT}) has reached the reference voltage, and in that the switching circuit (7) supplies the switched voltage (V_{HT'}) equal to the pumped voltage (V_{HT}) to the shaping circuit (2) when the control signal (SC) is active.

3. Memory according to Claim 1, characterised in that the control means include a time-delay circuit (5) for making the control signal (SC) active after a predetermined period has elapsed as from the starting of the charge pump (1), and in that the switching circuit (7) supplies the switched voltage (V_{HT'}) equal to the pumped voltage (V_{HT}) to the shaping circuit (2) when the control signal (SC) is active.

4. Memory according to Claim 1, characterised in that the control means include a voltage detection circuit (104) and a time-delay circuit (5) for making the control signal (SC) active as soon as the pumped voltage (V_{HT}) has reached a reference voltage or as soon as the charge pump (1) has been activated for a predetermined period, and in that the switching circuit (7) supplies the switched voltage (V_{HT},) equal to the pumped voltage (V_{HT}) to the shaping circuit (2) when the control signal (SC) is active.

5. Method of producing a programming or erasure voltage for a floating-gate memory during which a pumped voltage (V_{HT}) is produced by a charge pump (1) and a programming or erasure voltage (V_{PP}) is produced from the pumped voltage (V_{HT}) in a shaping circuit (2), the programming or erasure voltage (V_{PP}) having a progressive increase,
the method being characterised in that the pumped voltage (V_{HT}) is supplied to the shaping circuit (2) when an active control signal (SC) is received, the control signal (SC) being active when the pumped voltage (V_{HT}) has reached a sufficient voltage level.

6. Method according to Claim 5, characterised in that the control signal (SC) becomes active as soon as the pumped voltage (V_{HT}) has reached the reference voltage.

7. Method according to Claim 5, characterised in that the control signal (SC) becomes active as soon as a predetermined period has elapsed after the start of the pumping of the pumped voltage (V_{HT}).

8. Method according to Claim 5, characterised in that the control signal (SC) becomes active as soon as the pumped voltage (V_{HT}) has reached a reference voltage or as soon as a predetermined period has elapsed after the start of the pumping of the pumped voltage (V_{HT}).
